# EUROPEAN PATENT APPLICATION

(11) **EP 4 565 033 A1**
(43) Date of publication of application: **04.06.2025**
(21) Application number: 24216027.3
(22) Date of filing: 28.11.2024
(51) Int. Cl.: H10D 84/01, H10D 30/01, H10D 30/00, H10D 84/03, H10D 84/83

(54) **BACK-SIDE NANORIBBON REMOVAL**

(30) Priority: 29.11.2023 US 202318522572
(71) Applicant: Intel Corporation, Santa Clara, CA 95054 (US)
(72) Inventor: HUANG, Chiao-Ti, Portland, 97229 (US); CHU, Tao, Portland, 97229 (US); XU, Guowei, Portland, 97229 (US); CHAO, Robin, Portland, 97209 (US); Zhang, Kan, Hillsboro, 97123 (US); ZHANG, Yang, Rio Rancho, 87124 (US); HUNG, Ting-Hsiang, Beaverton, 97007 (US); Zhang, Feng, Hillsboro, 97123 (US); MURTHY, Anand S., Portland, 97229 (US); GHANI, Tahir, Portland, 97229 (US)
(74) Representative: 2SPL Patentanwälte PartG mbB

(57) **Abstract**

Fabrication methods for integrated circuit (IC) structures and devices involving back-side nanoribbon removal are described herein. In one example, back-side nanoribbon removal involves providing stacks of nanoribbons from a first side of an IC structure, followed by removing one or more of the nanoribbons from a second side that is opposite the first side. In one example, an IC structure fabricated with back-side nanoribbon removal techniques may include a first stack of nanoribbons over a support and a second stack of nanoribbons over the support, where the number of nanoribbons in the first stack is less than in the second stack. A first transistor includes first channel regions in the nanoribbons of the first stack and a second transistor includes second channel regions in the nanoribbons of the second stack. Therefore, in one such example, the first transistor has channel regions in fewer nanoribbons than the second transistor.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIG. 2 illustrates an example of an IC structure including stacks of nanoribbons having a different number of nanoribbons.
FIGS. 3A-3B are a flow diagram of an example method of fabricating an IC structure including back-side nanoribbon removal techniques, in accordance with some embodiments.
FIGS. 4-21 provide cross-sectional side views at various stages in the fabrication of an example IC structure according to the method of FIGS. 3A-3B, in accordance with some embodiments.
FIG. 22 is a top view of a wafer and dies that may include any of the IC structures disclosed herein, in accordance with any of the embodiments disclosed herein.
FIG. 23 is a side, cross-sectional view of an IC device that may include any of the IC structures disclosed herein, in accordance with any of the embodiments disclosed herein.
FIG. 24 is a side, cross-sectional view of an IC package that may include any of the IC structures disclosed herein, in accordance with various embodiments.
FIG. 25 is a side, cross-sectional view of an IC device assembly that may include any of the IC structures disclosed herein, in accordance with any of the embodiments disclosed herein.
FIG. 26 is a block diagram of an example electrical device that may include any of the IC structures disclosed herein, in accordance with any of the embodiments disclosed herein.

### Detailed Description

Disclosed herein is a fabrication method including back-side nanoribbon removal and associated IC structures, and devices. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating fabrication of nanoribbon-based transistors using back-side nanoribbon removal, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of metal-oxide-semiconductor (MOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer; also referred to herein as, simply, "support") over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

Typically, nanoribbon-based transistor arrangements include stacks of nanoribbons, where each stack includes two or more nanoribbons stacked above one another, with a single gate stack that includes a gate electrode material provided for an entire stack or multiple stacks. Optionally, the gate stack may also include a gate dielectric material around one or more channel regions of each nanoribbon.

Different applications for nanoribbon transistors may have different desired electrical characteristics and performance targets. For example, devices used in lower power applications are typically designed to minimize power consumption, while devices used in high performance applications may be designed to maximize speed. Various factors affect the power consumption and speed of a transistor. For example, in nanoribbon transistor technology, one technique for fabricating different transistors for low-power or high-performance applications is to use different nanoribbon widths. For example, a larger nanoribbon width can enable increased current conduction through the transistor for higher performance devices. A smaller nanoribbon width can enable reduced current conduction through the transistor for lower power applications.

Fabricating devices having different nanoribbon widths can be challenging due to width constraints (e.g., the minimum and maximum nanoribbon widths) due to process and yield limitations. For example, forming nanoribbons with an excessively large width can result in low yield due to the proximity of the metal gate to the nanoribbon edge. Similarly, fabricating nanoribbons with an excessively small width can result in yield issues due to the fin being easily damaged or broken (e.g., during fin patterning).

Another challenge in providing devices having different nanoribbon widths stems from differences in processing results for nanoribbons having different widths. Devices having different nanoribbon widths may be formed on the same wafer, however, the same processes can yield different results for openings with narrow widths compared to openings with wider widths. For example, in an etching process, fewer etchants may reach the bottom of a narrow opening than of a wide opening, resulting in a different etch rate. The phenomenon of such width-dependent process differences may be referred to as micro-loading and can result in geometry differences in the final devices. Improving uniformity in the geometry of devices having different nanoribbon widths can require significant additional processing.

In contrast, back-side nanoribbon removal techniques can enable the fabrication of nanoribbon transistors for both high performance and low-power applications while minimizing some of the width-dependent process challenges that can result from different nanoribbon widths. In one example, back-side nanoribbon removal involves providing stacks of nanoribbons from a first side (referred to herein as a front side) of the IC structure, followed by removing one or more of the nanoribbons from a second side that is opposite the first side (referred to herein as a back side). In one example, an IC structure fabricated with back-side nanoribbon removal techniques includes a first stack of nanoribbons over a support and a second stack of nanoribbons over the support, where the number of nanoribbons in the first stack is less than in the second stack (e.g., due to back-side removal of one or more nanoribbons from the first stack). A first transistor includes first channel regions in the nanoribbons of the first stack and a second transistor includes second channel regions in the nanoribbons of the second stack. Therefore, in one such example, the first transistor has channel regions in fewer nanoribbons than the second transistor.

IC structures as described herein, in particular IC structures fabricated using back-side nanoribbon removal techniques, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

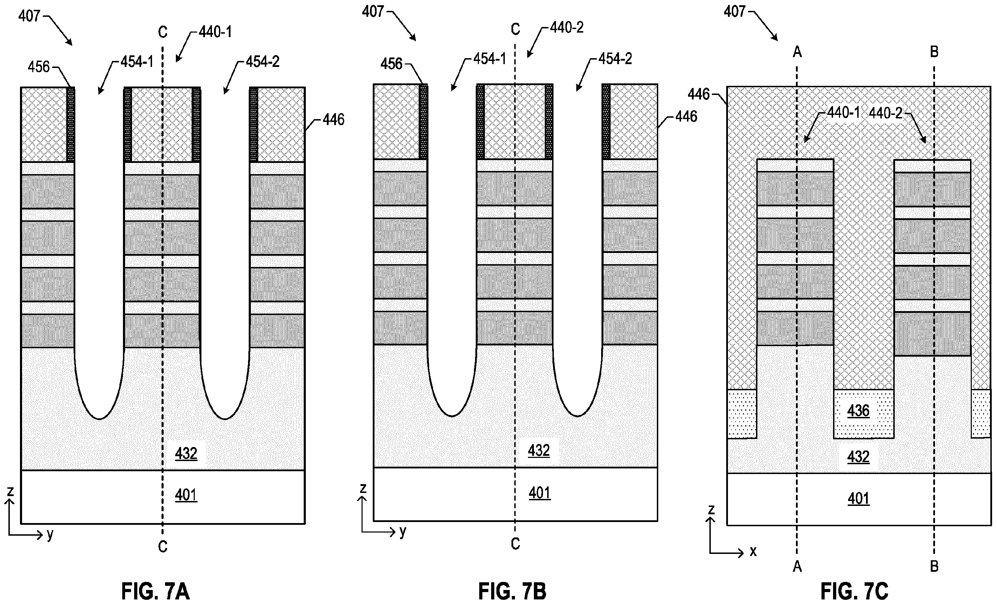

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 7A-7C, such a collection may be referred to herein without the letters, e.g., as "FIG. 7."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of the presence of IC structures fabricated using back-side nanoribbon techniques as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

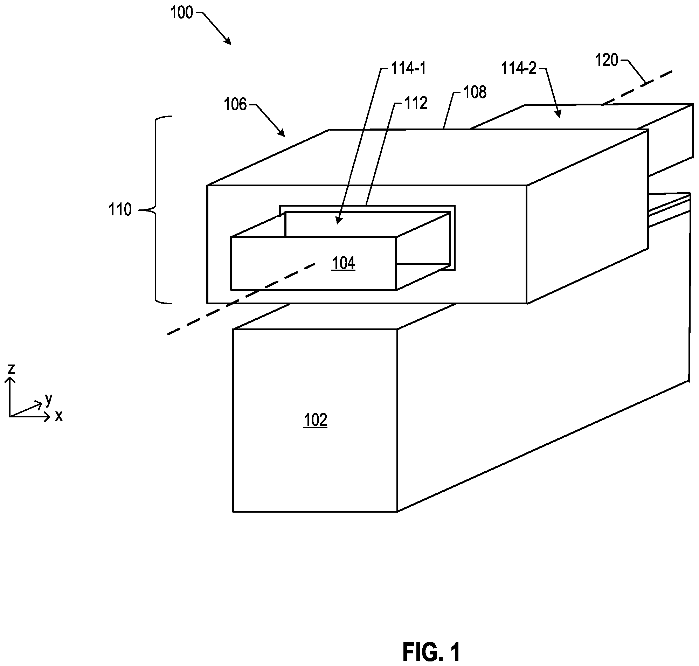

FIG. 1 provides a perspective view of an example IC structure 100 with a nanoribbon transistor 110, according to some embodiments of the present disclosure. As shown in FIG. 1, the IC structure 100 includes a semiconductor material formed as a nanoribbon 104 extending substantially parallel to a support 102. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2 (referred to herein as simply "S/D regions 114), on either side of the gate stack 106. One of the S/D regions 114 is a source region and the other one is a drain region. However, because, as is common in the field of FETs, designations of source and drain are often interchangeable, they are simply referred to herein as a first S/D region 114-1 and a second S/D region 114-2.

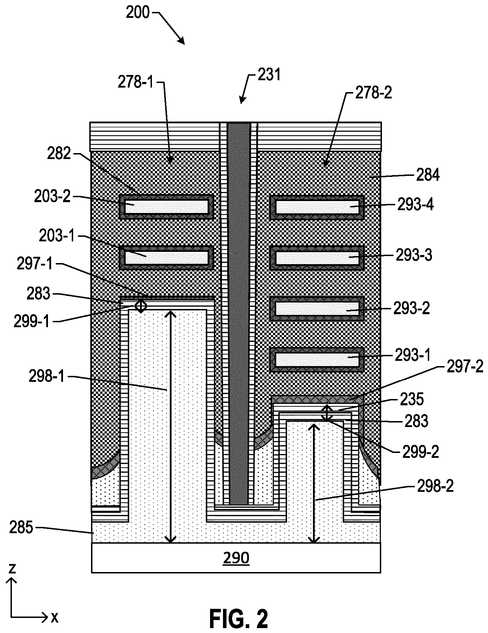

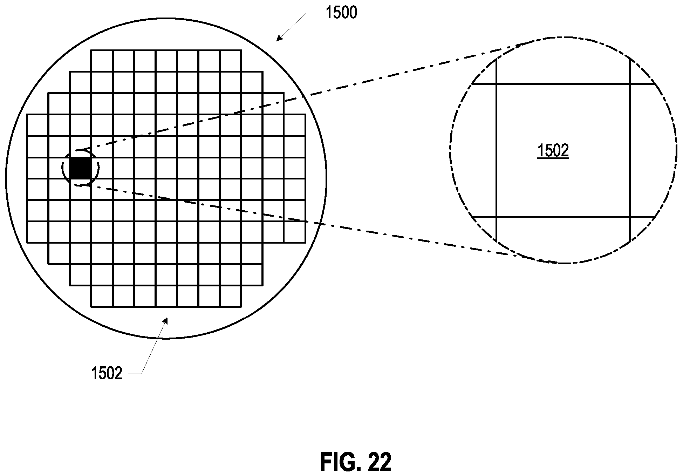

Implementations of the present disclosure may be formed or carried out on any suitable support 102, such as a substrate, a die, a wafer, or a chip. The support 102 may, e.g., be the wafer 1500 of FIG. 22, discussed below, and may be, or be included in, a die, e.g., the singulated die 1502 of FIG. 22, discussed below. The support 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 102 may be a printed circuit board (PCB) substrate, a package substrate, an interposer, a wafer, or a die. Although a few examples of materials from which the support 102 may be formed are described here, any material that may serve as a foundation upon which an IC structure including stacks of nanoribbons having a different number of nanoribbons as described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another. For example, FIG. 2, and FIGS. 20-21 show IC structures that may be examples of the IC structure 100. In some embodiments, a portion of the support 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transversal cross-section of the nanoribbon 104 (i.e., an area in the x-z plane of an x-y-z coordinate system shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 102 and in a direction perpendicular to the longitudinal axis 120 of the nanoribbon 104, e.g., along the x-axis of the coordinate system) may be at least about 3 times larger than a height or thickness of the nanoribbon 104 (i.e., a dimension measured in a plane perpendicular to the support 102, e.g., along the z-axis of the coordinate system), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 106 including a gate electrode material 108 and, optionally, a gate insulator material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate insulator material 112 may wrap around a transversal portion of the nanoribbon 104 and the gate electrode material 108 may wrap around the gate insulator material 112.

The gate electrode material 108 may include one or more gate electrode materials, where the choice of the gate electrode materials may depend on whether the transistor 110 is a PMOS transistor or an NMOS transistor. For a PMOS transistor, gate electrode materials that may be used in different portions of the gate electrode material 108 may include, but are not limited to, ruthenium, palladium, platinum, cobalt, nickel, and conductive metal oxides (e.g., ruthenium oxide). For an NMOS transistor, gate electrode materials that may be used in different portions of the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of a plurality of gate electrode materials, where zero or more materials of the stack are workfunction (WF) materials and at least one material of the stack is a fill metal layer. Further materials/layers may be included next to the gate electrode material 108 for other purposes, such as to act as a diffusion barrier layer or/and an adhesion layer.

In some embodiments, the gate insulator material 112 may include one or more high-k dielectrics including any of the materials discussed herein with reference to the insulator material that may surround portions of the transistor 110. In some embodiments, an annealing process may be carried out on the gate insulator material 112 during fabrication of the transistor 110 to improve the quality of the gate insulator material 112. The gate insulator material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and S/D contacts of the transistor 110 and could be made of a low-k dielectric material, some examples of which have been provided above.

Turning to the S/D regions 114 of the transistor 110, in some embodiments, the S/D regions may be highly doped, e.g., with dopant concentrations of about 10²¹ cm⁻³, in order to advantageously form Ohmic contacts with the respective S/D contacts (not shown in FIG. 1), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 114.

The S/D regions 114 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114. An epitaxial deposition process may then be carried out to fill the recesses with material that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. And in further embodiments, one or more layers of metal and/or metal alloys may be used to form the S/D regions 114. In some embodiments, a distance between the first and second S/D regions 114 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114 of the transistor 110, additional layers such as a spacer layer around the gate electrode of the transistor 110, etc.). For example, although not specifically illustrated in FIG. 1, a dielectric spacer may be provided between a first S/D contact (which may also be referred to as a "first S/D electrode") coupled to a first S/D region 114-1 of the transistor 110 and the gate stack 106 as well as between a second S/D contact (which may also be referred to as a "second S/D electrode") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIG. 2 illustrates an example of an IC structure including stacks of nanoribbons having a different number of nanoribbons. The IC structure 200 includes a first stack 278-1 of nanoribbons and a second stack 278-2 of nanoribbons. The IC structure 200 further includes a conductive material 284 around channel portions in the one or more nanoribbons of the stacks 278-1, 278-2. The conductive material 284 may be the same as or similar to the gate electrode material discussed above with respect to FIG. 1. The IC structure 200 may also include a gate insulator material 282 between the channel portions and the conductive material 284.

In the example illustrated in FIG. 2, the first stack 278-1 includes two nanoribbons 203-1, 203-2 and the second stack 278-2 includes four nanoribbons 293-1-293-4. Thus, in the illustrated example, one of the stacks has twice the number of nanoribbons than the other stack. In one example, the stack 278-1 of nanoribbons has fewer nanoribbons than the adjacent stack 278-2 of nanoribbons because the bottom two nanoribbons of the first stack 278-1 were removed (e.g., in accordance with back-side nanoribbon removal techniques described herein). In other examples, the stacks 278-1, 278-2 may include a different number of nanoribbons than depicted (e.g., one nanoribbon, three nanoribbons, or more than four nanoribbons).

Although the term "stack" typically refers to multiple nanoribbons stacked over one another, references to a stack of nanoribbons herein may refer to a single nanoribbon (e.g., a stack of nanoribbons in which all but one of the nanoribbons were removed). For example, a first stack of nanoribbons may have a single nanoribbon and a second stack may have a number of nanoribbons greater than one (e.g., two, three, four, or more than four nanoribbons). In another example, a first stack of nanoribbons has two nanoribbons, and a second stack may have a number of nanoribbons greater than two (e.g., three, four, or more than four nanoribbons). Various combinations are possible as long as at least one stack of nanoribbons (e.g., the stack 278-1) has at least one fewer nanoribbon than a second stack of nanoribbons (e.g., the stack 278-2). Although only two stacks 278-1, 278-2 are shown, in other examples, an IC structure can include three or more stacks of nanoribbons having different numbers of nanoribbons. For example, one stack may include one nanoribbon, a second stack may include two nanoribbons, a third stack may include three nanoribbons, etc.

Additionally, although the stacks 278-1, 278-2 are depicted as being adjacent stacks (separated by a via 231), the stacks of nanoribbons having different numbers of nanoribbons may not necessarily be adjacent to one another. Although the stacks 278-1, 278-2 may not necessarily be adjacent to one another, the stacks 278-1, 278-2 include nanoribbons in the same planes or layers. For example, the IC structure 200 includes a stack 278-2 of nanoribbons over the support 290, including a first nanoribbon (e.g., the nanoribbon 293-2) in a first plane substantially parallel to the support 290 and a second nanoribbon (e.g., the nanoribbon 293-3) stacked over the first nanoribbon in a second plane substantially parallel to the support 290. The IC structure 200 also includes a third nanoribbon over the support (e.g., the nanoribbon 203-1) in the same plane as the nanoribbon 293-3. Thus, in one example, an individual nanoribbon of the first stack is in a substantially same layer as a corresponding individual nanoribbon of the second stack. However, the IC structure 200 does not include a nanoribbon under the nanoribbon 203-1 in the same plane or layer with the nanoribbon 293-2 (e.g., due to removal of the nanoribbon that was previously stacked under the nanoribbon 203-1). Instead, in one example, the IC structure 200 includes an insulator material (e.g., the insulator material 285 and/or the liner 283) under the nanoribbon 203-1 in substantially the same plane as the nanoribbon 293-2.

In addition to the different numbers of nanoribbons in the stacks 278-1, 278-2, the IC structure 200 depicted in FIG. 2 includes differences in a liner and insulator material under the stacks. For example, the IC structure 200 depicts that a volume of the insulator material 285 under the stack 278-1 is greater than a volume of the insulator material 285 under the stack 278-2, where the volume of the insulator material under a stack refers to a materially continuous insulator material between the stack and a support. In one such example, the thickness or height 298-1 of the insulator material 285 under the stack 278-1 is greater than the thickness or height 298-2 of the insulator material 285 under the stack 278-2, where the thickness or height 298-1, 298-2 of the insulator material 285 is a dimension of the insulator material in a plane substantially perpendicular to the support 290. In one example, the volume of the insulator material 285 under a stack is the volume in an area defined by the height (e.g., the height 298-1 or 298-2) of the continuous insulator material 285 between a material above and below the insulator material (e.g., between the liner 283 and a support or other material under the insulator material 285), a width of the insulator material 285 between sidewalls of an opening under the stack (where the width of the insulator material is a dimension along the x-axis shown in FIG. 2 and parallel to the width of the nanoribbons of the stack), and a length of the insulator material 285 (where the length of the insulator material is a dimension along the y-axis, where the y-axis is coming out of and going into the page in FIG. 2 and parallel to the length of the nanoribbons of the stack).

Also as shown in FIG. 2, the thickness 299-2 of a liner (e.g., the liners 235, 283) between the stack 278-2 and the insulator material 285 is greater than a thickness 299-1 of a liner 283 between the stack 278-1 of nanoribbons and the insulator material 285, where thickness of the liner is a dimension of the liner in a plane substantially perpendicular to the support 290. In one such example, the IC structure 200 includes two liners 235, 283 under the stack 278-2 of nanoribbons in which nanoribbons were not removed, and a single liner 283 under the stack 278-1 of nanoribbons in which nanoribbons were removed. In one such example, the material composition of the liners 235, 283 may be substantially the same, resulting in the two liners 235, 283 appearing as a single liner with a greater thickness than the liner 283 under the stack 278-1. However, in other examples, there may not be differences in the liners in stacks of nanoribbons having different numbers of nanoribbons. In one example, a gate insulator material 287-1 between the bottom nanoribbon 203-1 of the stack 278-1 and the insulator material 285 may have different properties than the gate insulator material 297-2 between the bottom nanoribbon 293-1 of the stack 278-2 and the insulator material 285. For example, the gate insulator material 297-1 may be thinner or have a different material composition compared to the gate insulator material 297-2 (e.g., as a result of the etching processes used to remove nanoribbons from the stack 278-1).

Transistors having different numbers of nanoribbons may be formed in the stacks 278-1, 278-2. For example, the nanoribbons 203-1, 203-2 include channel regions of a first transistor, and the nanoribbons 293-1-293-4 in the stack 478-2 include channel regions of a second transistor. Thus, the transistors formed from the stacks 278-1, 278-2 of nanoribbons may have channel regions in a different number of nanoribbons. Transistors having channel regions in different numbers of nanoribbons may have different properties that make the transistors more suitable for low-power or high-performance applications. For example, a transistor with channel regions in two nanoribbons (such as in the stack 278-1) may conduct less (e.g., about half) as much current as a transistor with channel regions in four nanoribbons (such as in the stack 278-2). The additional insulator material under the stack with fewer nanoribbons (such as the stack 278-1) may also result in a transistor with lower capacitance than a transistor formed in a stack with more nanoribbons (such as the stack 278-2). Thus, different transistors for low-power or high-performance applications can be formed with different numbers of nanoribbons. Note that transistors having different numbers of nanoribbons may have the same or different nanoribbons widths. Thus, in some examples, transistors having a variety of electrical characteristics may be fabricated by adjusting the number of nanoribbons and the width of the nanoribbons in which the transistors are formed.

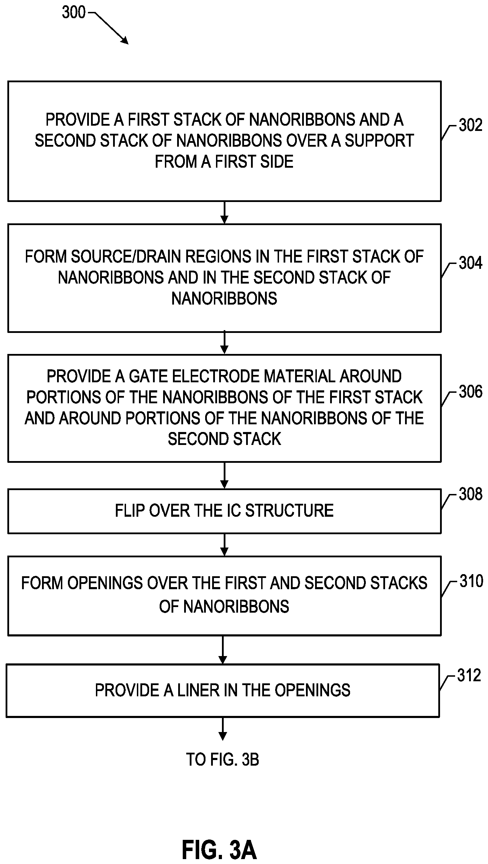

FIGS. 3A-3B are a flow diagram of an example method for fabricating an IC structure including back-side nanoribbon removal techniques, in accordance with some embodiments.

Although the operations of the method of FIGS. 3A-3B are illustrated once each and in a particular order, the operations may be performed in any suitable order and repeated as desired. For example, one or more operations may be performed in parallel to fabricate multiple IC structures with different numbers of nanoribbons substantially simultaneously. In another example, the operations may be performed in a different order to reflect the structure of an IC device fabricated using back-side nanoribbon removal techniques.

In addition, the example fabricating method of FIGS. 3A-3B may include other operations not specifically shown in FIGS. 3A-3B, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the method of FIGS. 3A-3B described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

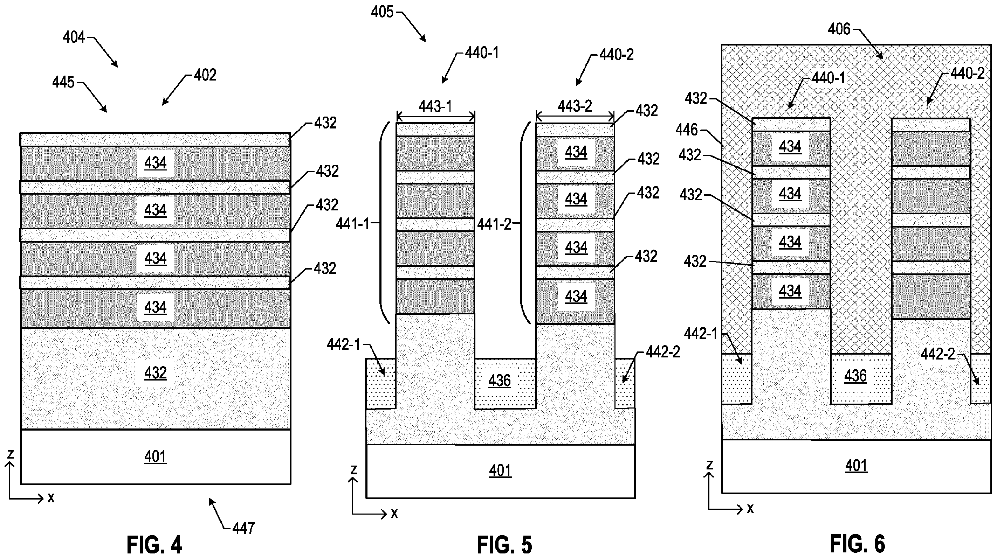

FIGS. 4-21 provide cross-sectional side views at various stages in the fabrication of an example IC structure according to the method of FIGS. 3A-3B, in accordance with some embodiments. Some of FIGS. 4-21 (e.g., FIG. 7, FIG. 8, FIG. 18, and FIGS. 19-21) include three figures, labeled with letters A, B, and C (e.g., FIG. 7 includes FIGS. 7A, 7B, and 7C), providing different cross-sectional side views of a given IC structure. In particular, those figures of FIGS. 4-21 that are labeled with a letter A (e.g., FIG. 7A) illustrate cross-sections in the y-z plane of the example coordinate system shown in FIG. 1 along a plane AA shown in a corresponding figure labeled with a letter C (e.g., along a plane AA shown in FIG. 7C). Those figures of FIGS. 4-21 that are labeled with a letter B (e.g., FIG. 7B) illustrate cross-sections in the y-z plane of the example coordinate system shown in FIG. 1 along a plane BB shown in a corresponding figure labeled with a letter C (e.g., along a plane BB shown in FIG. 7C). Those figures of FIGS. 4-21 that are labeled with a letter C (e.g., FIG. 7C) illustrate cross-sections in the x-z plane of the example coordinate system shown in FIG. 1 along a plane CC shown in FIG. 7A and FIG. 7B. In order to not clutter the drawings, planes AA, BB, and CC may not be shown in some of FIGS. 4-21. Those of FIGS. 4-21 that only show one cross-section, illustrate a cross-section in the x-z plane of the example coordinate system shown in FIG. 1 (i.e., those figures are similar to figures labeled with a letter C).

Turning to FIG. 3A, the method 300 begins with a process 302 of providing a first stack of nanoribbons and a second stack of nanoribbons over a support from a first side. Providing stacks of nanoribbons over a support may include, for example, providing a stack of alternate layers of a semiconductor material and another material (e.g., a second semiconductor material) and forming fins from the stack. A dummy gate can then be provided around gate regions of the fins. IC structures 404, 405, 406 of FIGS. 4-6 illustrate an example result of the process 302.

For example, the IC structure 404 of FIG. 4 illustrates an example result of providing a stack of alternate layers of a semiconductor material and another material from a first side 445 of the IC structure 404 (e.g., a front side of the IC structure 404, which may also be a front side of a wafer in or on which the IC structure 404 is formed). The IC structure 404 includes a support 401 and alternating layers of a semiconductor 432 and layers of another material 434. While FIG. 4 illustrates five layers of the semiconductor material and four layers of the material 434 in a stack 402, in other embodiments, any other number of layers may be used as long as they are alternating and include at least three layers of the semiconductor material 432 and at least two layers of the material 434. The upper layers of the semiconductor material 432 will later be formed into nanoribbons stacked above one another, as shown in FIG. 5-21, discussed below. Thus, although a particular number of nanoribbons formed of the upper layers of the semiconductor material 432 is depicted in FIG. 5 (namely, four nanoribbons) and subsequent drawings, embodiments of the present disclosure include IC structures having more or fewer stacked nanoribbons than depicted.

As shown in FIG. 4, in some embodiments, the alternation of layers of the semiconductor material 432 and the material 434 may begin after a bottom layer of the semiconductor material 432 is provided over the support 401. In one such example, the bottom layer of the semiconductor material 432 may later form a subfin under the stack of nanoribbons. Although the thickness of the bottom layer of the semiconductor material 432 is depicted as being greater than the subsequent layers of the semiconductor material 432 that are formed into nanoribbons via further processing, in other examples, the bottom layer of the semiconductor material 432 may have a substantially same thickness as another layer of the semiconductor material 432.

The semiconductor material 432 may be any of the semiconductor/channel materials described above with reference to the nanoribbon 104 of FIG. 1. The material 434 may be any suitable material that is etch-selective with respect to the semiconductor material 432 so that, in a later process, the material 434 may be etched away to form nanoribbons of the semiconductor material 432. As known in the art, two materials are said to be "etch-selective" (or said to have "sufficient etch selectivity") with respect to one another when etchants used to etch one material do not substantially etch the other, enabling selective etching of one material but not the other. For example, in some embodiments, the semiconductor material 432 may be silicon while the material 434 may be a second semiconductor material such as silicon germanium. In another example, the semiconductor material 432 may be silicon germanium, while the material 434 may be silicon. In other examples, the material 434 may be made of a non-semiconductor material, e.g., of an insulator material, as long as this material is sufficiently etch-selective with respect to the semiconductor material 432.

Thus, the material 434 may be any suitable sacrificial material that is etch-selective with respect to the semiconductor material 432. Selecting the material 434 to be a semiconductor material may be particularly advantageous because it may improve quality of the semiconductor material 432 if the semiconductor material 432 is epitaxially grown on the material 434. In some embodiments, the process 302 may include epitaxially growing layers of the semiconductor material 432 and the material 434 (e.g., a second semiconductor material) in an alternating manner. In other embodiments, alternate layers of the semiconductor material 432 and the material 434 may be provided in the process 302 using other techniques, such as layer transfer or thin-film deposition. Although FIG. 4 illustrates the same semiconductor material 432 in various layers of the IC structure 404, in general, material compositions of a semiconductor material from which nanoribbons will later be formed in different layers of the IC structure 404 may be different. For example, the semiconductor material 432 of one layer of the IC structure 404 may be silicon while the semiconductor material 432 of another layer of the IC structure 404 may be a III-N semiconductor material such as GaN.

FIG. 5 illustrates an example of an IC structure 405 resulting from the process of forming fins from the stack of alternate layers of semiconductor material and another material. The IC structure 405 illustrates that the stack 402 of alternating layers of the semiconductor material 432 and the material 434 has been patterned into fins 440-1, 440-2. The fins 440-1, 440-2 may include active portions 441-1, 441-2 and subfin portions 442-1, 442-2. The active portions 441-1, 441-2 may be portions of the fins 440-1, 440-2 from which the respective nanoribbons will be formed, while the subfin portions 442-1, 442-2 are portions of the fins 440-1, 440-2 that have sidewalls at least partially enclosed with an insulator material 436, e.g., as shown in FIG. 5. The insulator material 436 may include any of insulator material typically used as a "shallow trench insulator" (STI) in fin-based or nanoribbon-based transistors, e.g., any suitable low-k dielectric material or other suitable insulator material.

Thus, each of the fins 440-1, 440-2 may be shaped as a structure that extends away from the support 401 and may include a subfin 442-1, 442-2 at the bottom, the subfin being a portion of the respective fin that is at least partially enclosed by an insulator material 436. In some embodiments, the subfins 442-1, 442-2 may include the bottom layer of the semiconductor material 432, as well as an upper portion of the support 401, as is shown in FIG. 5. However, in other embodiments, the subfins 442-1, 442-2 may include only the semiconductor material 432 and not any portions of the support 401 (not shown in the present drawings). In some embodiments, semiconductor material 432 of the subfins 442-2, 442-2 and/or the support 401 may be removed and/or replaced with one or more other materials in subsequent processes.

In some embodiments, the fins 440-1, 440-2 may have widths (i.e., a dimension of the fins 440-1, 440-2 measured along the x-axis of the example coordinate system shown in FIG. 5) that are substantially the same or different. For example, the fin 440-1 has a width 443-1 and the fin 440-2 has a width 443-2. The widths 443-1, 443-2 may be that of the width of the nanoribbons subsequently formed (e.g., the nanoribbon 104 of FIG. 1 described above). The fins 440-1, 440-2 may further have a length (i.e., a dimension of the fins 440-1, 440-2 measured along the y-axis of the example coordinate system shown in FIG. 5, where the y-axis is going into and coming out of the page) suitable to account for the length of the future nanoribbons (e.g., as described above with reference to the length of the nanoribbon 104 of FIG. 1).

In various embodiments, any suitable patterning techniques may be used to form the fins 440-1, 440-2, such as, but not limited to, photolithographic or electron-beam (e-beam) patterning, possibly in conjunction with a suitable etching technique, e.g., a dry etch, such as e.g., RF reactive ion etch (RIE) or inductively coupled plasma (ICP) RIE. In some embodiments, the etch performed to form the fins 440-1, 440-2 may include an anisotropic etch, using etchants in a form of e.g., chemically active ionized gas (i.e., plasma) using e.g., bromine (Br) and chloride (CI) based chemistries. In some embodiments, during the etch to form the fins 440-1, 440-2, the IC structure may be heated to elevated temperatures, e.g., to temperatures between about room temperature and 200 degrees Celsius, including all values and ranges therein, to promote that byproducts of the etch are made sufficiently volatile to be removed from the surface.

After forming the fins 440-1, 440-2, a dummy gate material may then be provided around gate regions of the fins. FIG. 6 illustrates an example IC structure 406 resulting from the process of providing a dummy gate. The IC structure 406 illustrates the fins 440-1, 440-2 over the support 401 and a material 446, which may be referred to as the dummy gate or replacement gate. In one example, the material 446 may be any suitable material such as polysilicon.

Referring again to FIG. 3A, the method 300 continues with a process 304 of forming source/drain (S/D) regions in the first stack of nanoribbons and in the second stack of nanoribbons. Forming S/D regions may involve, for example, forming S/D openings for the S/D regions in the fins, recessing a sacrificial material in the openings, providing a spacer material in the recessed areas, and providing an S/D material in the openings. IC structures 407 and 408 of FIGS. 7-8 illustrate example results of the process 304.

FIGS. 7A-7C illustrate the IC structure 407 resulting from the process of forming S/D openings in the fins 440-1, 440-2. Specifically, FIG. 7A and FIG. 7B illustrate the IC structure 407 after forming S/D openings from the perspective of the y-z plane in a cross-section along the fins 440-1, 440-2, respectively. FIG. 7C illustrates the IC structure 407 after forming S/D openings from the perspective of the x-z plane. FIG. 7A and FIG. 7B illustrate a first opening 454-1 and a second opening 454-2 (together referred to as "openings 454") in each of the fins 440-2, 440-2. Any suitable etching technique may be used to form the openings 454, such as the techniques described above with respect to the process of forming the fins. In some embodiments, portions of the openings 454 surrounded by the dummy gate 446 may be lined with a liner 456, which may include a plurality of different liners even though it is shown in FIG. 7A and FIG. 7B as a single liner 456. The liner 456 may include one or more of spacer materials, diffusion barrier materials, adhesion materials, etc., as known in the art for forming contacts to various components of IC structures.

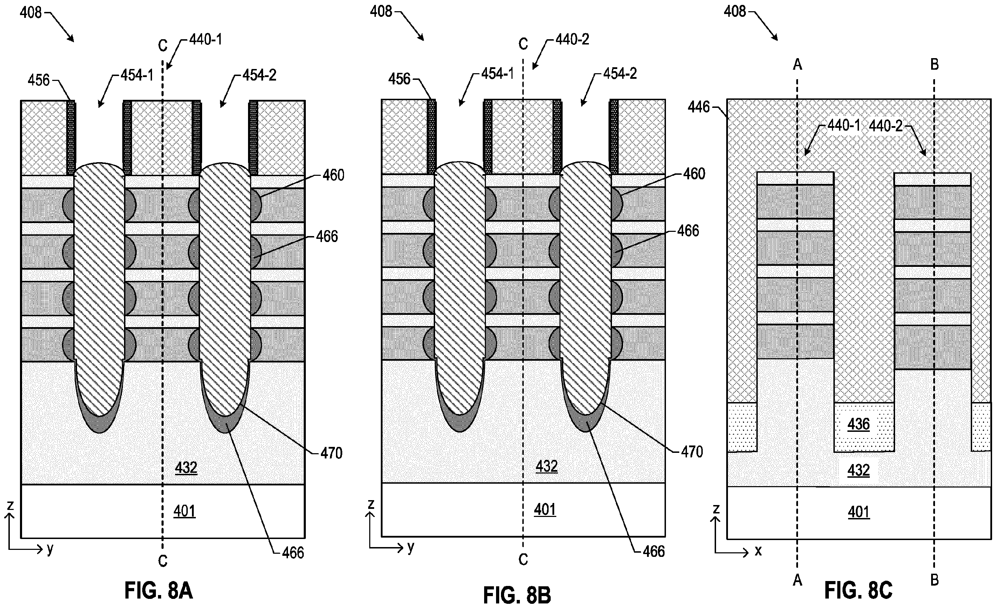

FIGS. 8A-8C illustrate the IC structure 408 resulting from the process of recessing a sacrificial material in the openings and providing a spacer material and S/D material in the openings. As can be seen in FIG. 8A and FIG. 8B, as a result of recessing the material 434, so-called "dimples" 460 may be formed in the sidewalls of the S/D openings 454 in the fins 440-1, 440-2, where the dimples 460 are areas in which the material 434 was recessed away from the original sidewalls of the openings 454 (i.e., recessed laterally). Any suitable etching technique may be used in the process to recess the material 434 in the S/D openings 454, such as any suitable wet etching technique using etchants that can etch the material 434 without substantially etching other material of the IC structure 408. The dimples 460 may have any suitable geometry and dimensions so that, when filled with an insulator material in a later process, the dimples 460 may provide electrical insulation between the material of the S/D regions that will be within the S/D openings 454 formed in the fins 440-1, 440-2 and the gate electrode material that will be present between the nanoribbons of the semiconductor material 432 formed from the fins 440-1, 440-2. For example, a depth of the dimples 460, which is a dimension that is measured along the y-axis of the example coordinate system shown, may be between about 1 and 20 nanometers, e.g., between about 2 and 10 nanometers, or between about 3 and 7 nanometers.

FIG. 8A and FIG. 8B also illustrate a spacer material 466 and S/D material 470 for the S/D regions in the openings 454. In the example illustrated in FIG. 8A and FIG. 8B, the dimples 460 may be filled with a spacer material 466. Furthermore, the spacer material 466 may also line bottoms of the openings 454. In one such example, the spacer material 466 lines the subfin portion of the fins 440-1, 440-2. Remaining portions of the openings 454 may be filled with respective S/D materials, shown as a S/D material 470 in the openings 454. The spacer material 466 may include any suitable insulator material, while the S/D materials 470 may include any materials for forming S/D regions (e.g., such as the S/D regions 114 of FIG. 1) of nanoribbon-based transistors. In one example, the S/D material includes a doped semiconductor material. Techniques for filling S/D openings with a spacer material and S/D material during fabrication of nanoribbon-based transistors are known in the art and, therefore, are not described here in detail. Thus, FIG. 8 illustrates an example IC structure 408 of processes involved in forming S/D regions in the fins 440-1, 440-2.

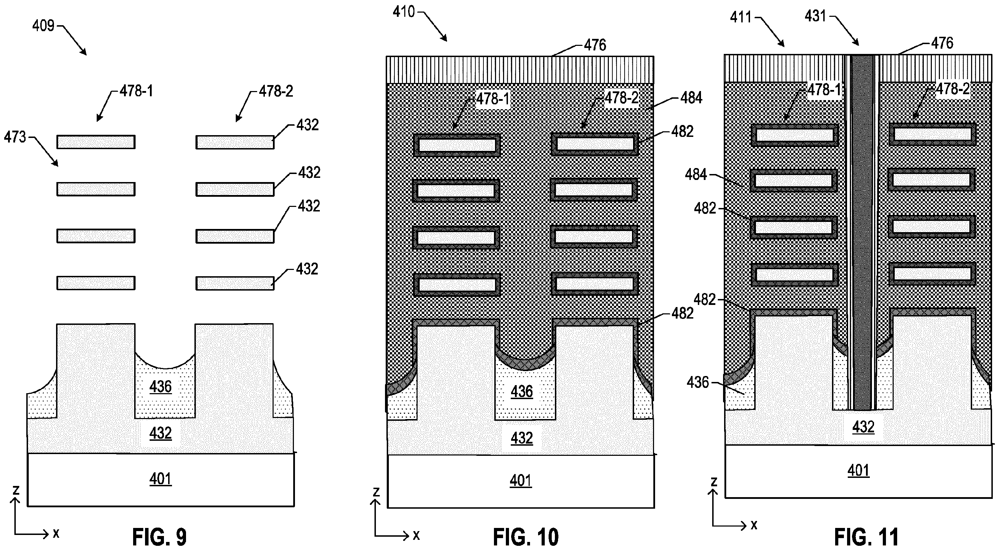

The method can then involve the process of removing the dummy gate material and releasing the nanoribbons. FIG. 9 illustrates an example IC structure 409 resulting from the process of removing the dummy gate and releasing the nanoribbons. Removal of the dummy gate 446 may include any suitable etching technique, provided the material of the dummy gate 446 is sufficiently etch-selective with respect to the other materials of the IC structure 409, in particular, with respect to the semiconductor material 432 and the insulator material 436 surrounding the subfin portion of the fins 440-1, 440-2. Removing the dummy gate exposes the material 434 and the semiconductor material 432 at the sidewalls of the fins 440-2, 440-2. An etch process may then be used to remove the material 434 from the fins 440-1, 440-2, starting from the portions of the material 434 that are exposed by the removal of the dummy gate 446. As a result of removing the material 434, a stack 478-1 of nanoribbons of the semiconductor material 432 is formed from the fin 440-1, and a stack 478-2 of nanoribbons of the semiconductor material 432 is formed from the fin 440-2. Thus, the nanoribbons of the stacks 478-1, 478-2 are "released" in that the openings 473 are formed around channel portions of the nanoribbons of the semiconductor material 432.

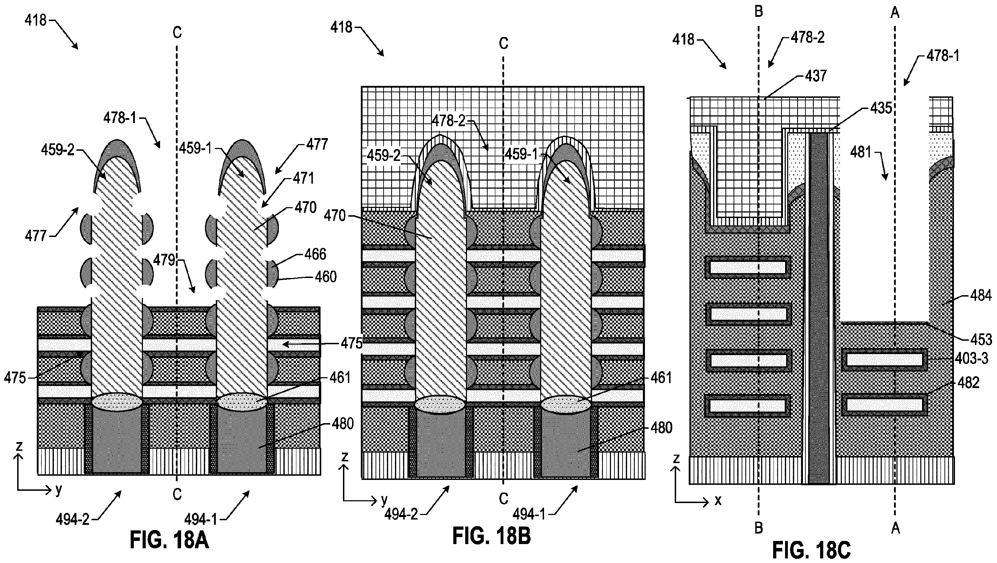

Referring again to FIG. 3A, the method 300 continues with the process 306 of providing a gate electrode material around portions of the nanoribbons of the first and second stacks. FIG. 10 illustrates an example IC structure 410 resulting from the process providing a gate electrode material 484 around portions of the nanoribbons of the first stack 478-1 and the second stack 478-2. The gate electrode material 484 may be the same as, or similar to, the gate electrode material 108 described above with respect to FIG. 1. FIG. 10 further illustrates a gate insulator material 482 that may wrap around the gate regions of the nanoribbons of the stacks 478-1, 478-2. The gate insulator material 482 may be the same as or similar to the gate insulator material 112 described above with respect to FIG. 2. In the example illustrated in FIG. 10, a layer of the gate insulator material 482 is also formed over the insulator material 436 and the semiconductor material 432 of the subfins under the stacks 478-1, 478-2. In some embodiments, the gate insulator material 482 may be absent in the IC structure 410. In the example illustrated in FIG. 10, an insulator material 476 is provided over the gate electrode material 484. The insulator material 476 can help prevent source/drain contact to gate shorts, and can be any suitable insulator material. Although not shown in FIG. 10, in one example, the method 300 further involves providing S/D contacts, which are described below with respect to FIG. 18.

In some examples, a conductive via may be formed between adjacent stacks of nanoribbons. FIG. 11 illustrates an example of an IC structure 411 in which a conductive via 431 is formed between the stack 478-1 of nanoribbons and the stack 478-2 of nanoribbons. In one such example, forming a via may involve forming an opening, providing a liner in the via opening, and filling the lined opening with a conductive material. In other examples, a conductive via may not be formed between two adjacent stacks of nanoribbons.

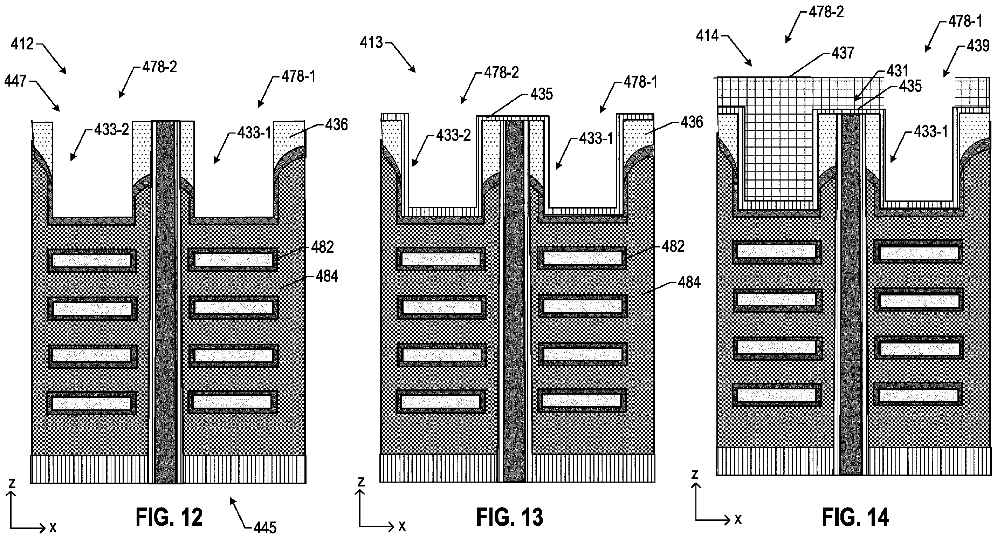

Referring again to FIG. 3A, the method 300 continues with the process 308 of flipping over the IC structure and the process 310 of forming openings over the first and second stacks of nanoribbons. An IC structure 412 of FIG. 12 illustrates an example result of the processes 308 and 310. Thus, the IC structure 412 is flipped over to expose a second side 447 (e.g., a back side) of the IC structure 412 that is opposite a first side 445 (e.g., a front side). Openings 433-1, 433-2 are then formed over the stacks 478-1, 478-2 of nanoribbons. In one example, forming the openings 433-1, 433-2 involves removing the support 401 and removing the semiconductor material 432 (e.g., some or all of the material of the subfins under the stacks of nanoribbons from the perspective of the first side of the IC structure, such as illustrated in FIGS. 9-11). Removing the semiconductor material 432 may include etching the semiconductor material 432, e.g., using anisotropic etching or another etching technique, without substantially etching the insulator material 436.

The method 300 continues with the process 312 of providing a liner in the openings. An IC structure 413 of FIG. 13 illustrates an example result of the process 312. As can be seen in FIG. 13, a liner 435 is on sidewalls and on a bottom of the openings 433-1, 433-2 formed over the stacks 478-1, 478-2 of nanoribbons. In the illustrated example, the liner 435 is also present on a surface of the insulator material 436 exposed by the removal of the support 401 and the semiconductor material 432 of the subfins. In one example, the liner 435 includes an insulator material. The insulator material of the liner 435 may include, for example, silicon nitride, silicon carbide, aluminum oxide, or another suitable insulator material.

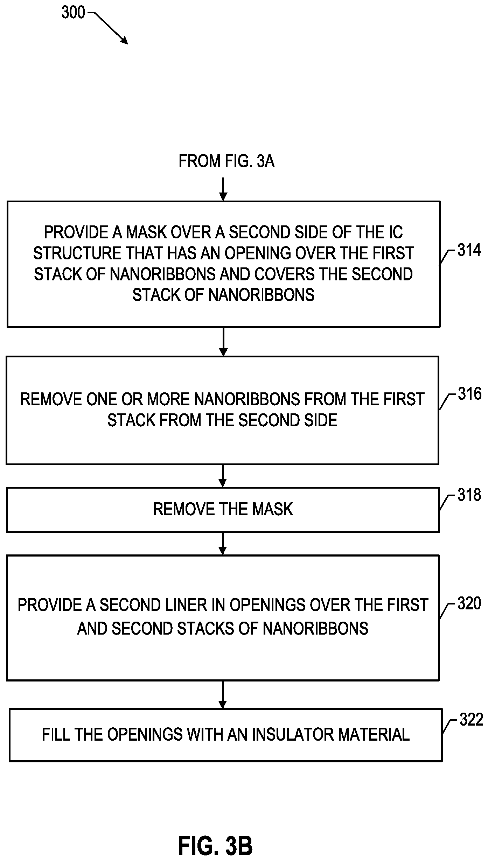

Turning now to FIG. 3B, the method 300 continues with the process 314 of providing a mask over a second side of the IC structure that has an opening over the first stack of nanoribbons and covers the second stack of nanoribbons. An IC structure 414 of FIG. 14 illustrates an example result of the process 314. As can be seen in FIG. 14, the mask 437 covers the stack 478-2 of nanoribbons and has an opening 439 over the stack 478-1 of nanoribbons. In the illustrated example, the mask 437 also covers the insulator material 436 and the conductive via 431. In one example, the gap or opening 439 in the mask 437 over the stack 478-1 has a width (e.g., a dimension along the x-axis in FIG. 14) to enable one or more nanoribbons of the stack 478-1 to be removed in a subsequent process while protecting other materials of the IC structure 414, such as the via 431, the stack 478-2 of nanoribbons, and the insulator material 436. The mask 437 can include, e.g., a carbon-based mask, any other suitable mask material.

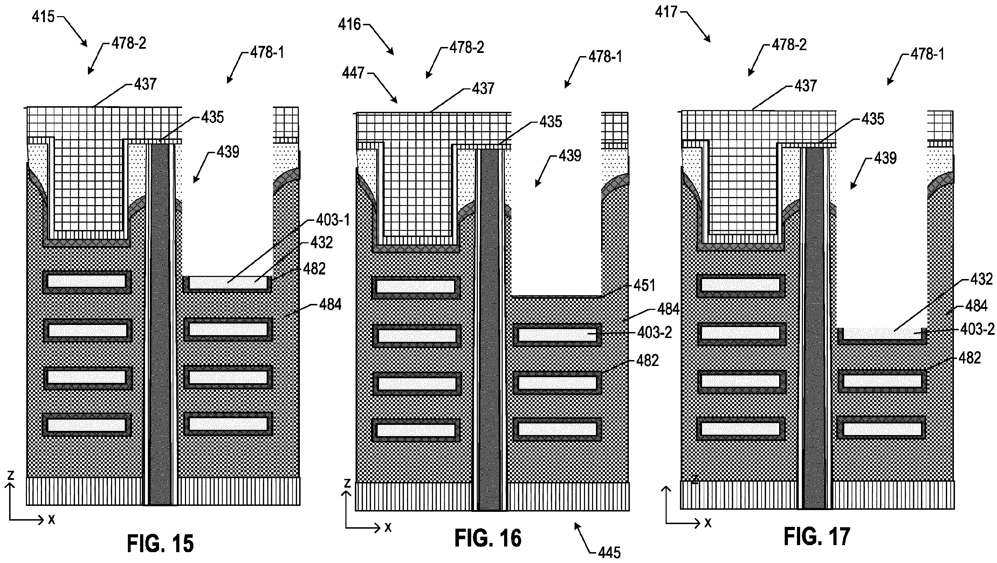

Referring again to FIG. 3B, the method 300 continues with the process 316 of removing one or more nanoribbons from the first stack of nanoribbons from the second side of the IC structure. In one example, removing one or more nanoribbons from the first stack involves etching an insulator material (e.g., gate insulator material 482), a conductive material (e.g., a gate electrode material 484), and a semiconductor material of one or more of the nanoribbons of the first stack (e.g., the semiconductor material 432 of the nanoribbon(s) to remove). IC structure 415-418 of FIGS. 14-18 illustrate example results of the process 316. Specifically, IC structures 415 and 416 of FIGS. 15-16 illustrate an example result of removing one nanoribbon from a stack of nanoribbons. IC structures 417 and 418 of FIGS. 17-18 illustrate an example result of removing two nanoribbons from a stack of nanoribbons.

Turning first to FIG. 15, the IC structure 415 is an example resulting structure after removing the liner 435 over the first stack 478-1 of nanoribbons, the gate insulator material 482 over the first stack 478-1 of nanoribbons (e.g., the layer of the gate insulator material 482 that was between the gate electrode material 484 and the subfin prior to forming the opening 433-1), and the gate electrode material 484 over the first stack 478-1 of nanoribbons (e.g., the gate electrode material 484 between the first stack 478-1 and the subfin prior to forming the opening 433-1). Removing the gate insulator material 482 and the gate electrode material 484 involves etching the gate insulator material 482 and the gate electrode material 484 through the opening 439 in the mask 437 using any suitable etching techniques. For example, the gate electrode material 484 may be removed via a wet etch process or other suitable etching technique. In one example, the gate insulator material 482 may be removed with a dry etch process or other suitable etching technique. In one example, the etching process to remove the gate insulator material 482 and/or the gate electrode material 484 stops at the semiconductor material 432 of the nanoribbon 403-1.

FIG. 16 illustrates an example IC structure 416 after further removing the semiconductor material 432 of the nanoribbon 403-1. Removing the semiconductor material 432 of the nanoribbon 403-1 may involve, e.g., using anisotropic etching or another etching technique, through the opening 439 in the mask 437 without substantially etching the surrounding gate electrode material 484. For example, the semiconductor material 432 may be removed with a wet etch process, a dry etch process, or other suitable etch process. In one example, the etching process to remove the semiconductor material 432 of the nanoribbon 403-1 stops at the gate insulator material 482 (e.g., the remaining gate insulator material 451 that was surrounding the gate region of the nanoribbon 403-1 prior to removal of the nanoribbon 403-1). Thus, FIG. 16 depicts an IC structure 416 in which one nanoribbon has been removed from the stack 478-1 from the second side 447 of the IC structure 416. In some examples, only a single nanoribbon from a stack is to be removed. In other examples, multiple nanoribbons from the stack are to be removed.

In examples in which multiple nanoribbons are to be removed, removal of the nanoribbons may involve cyclically etching an insulator material (e.g., the gate insulator material), a conductive material (e.g., the gate electrode material), and a semiconductor material (e.g., the semiconductor material of the nanoribbons to be removed). FIGS. 17-18 depict example IC structures 417 and 418 of removing two nanoribbons from the first stack. FIG. 17 depicts an example IC structure 417 in which the gate insulator material 482 and the gate electrode material 484 between the nanoribbons 403-1 and 403-2 has been removed. Removing the gate insulator material 482 and the gate electrode material 484 between the nanoribbons 403-1 and 403-2 may involve the same techniques as described with respect to FIG. 15. In one such example, the etching process to remove the gate insulator material 482 and the gate electrode material 484 stops at the semiconductor material 432 of the nanoribbon 403-2.

The method 300 may then continue with removing the semiconductor material 432 of the nanoribbon 403-2. An IC structure 418 of FIG. 18 illustrates an example result of removing the semiconductor material 432 of the nanoribbon 403-2. Removing the semiconductor material 432 of the nanoribbon 403-2 may involve the same techniques as discussed above with respect to FIG. 16. In one example, the etching process to remove the semiconductor material 432 of the nanoribbon 403-2 stops at the gate insulator material 482 (e.g., the remaining gate insulator material 453 that was surrounding the gate region of the nanoribbon 403-2, as shown in FIG. 18C). After removing the second nanoribbon, the IC structure 418 includes an opening 481 over the stack 478-1 of nanoribbons.

In one example, etching the semiconductor material of one or more of nanoribbons may result in etching (unintentionally or intentionally) a semiconductor material of a source region and/or a drain region adjacent to the semiconductor material of the nanoribbon(s) being removed. For example, FIGS. 18A-18C illustrate an example IC structure 418 in which the semiconductor material of an S/D region has been etched as a result of the back-side nanoribbon removal. Specifically, FIGS. 18A-18B illustrate the IC structure 418 from the perspective of the y-z plane. FIG. 18C illustrates the IC structure 418 from the perspective of the x-z plane. The IC structure 418 includes S/D regions 459-1, 459-2 in each fin 440-1, 440-2 and thus in each stack 478-1, 478-2 of nanoribbons. The S/D regions include an S/D material 470 that make electrical contact with S/D contacts 494-1, 494-2 (referred to herein as simply "S/D contacts 494"). In the example illustrated in FIG. 18, the IC structure 418 further includes an interface material 461 to provide an interface between the S/D material 470 of the S/D regions 459 and an electrically conductive fill material 480 of the S/D contacts 494. The interface material 461 may include/be a metal such as titanium which, once deposited, may intermix with the material of the S/D regions 459, e.g., with silicon, forming a compound (e.g., titanium silicide) that may help reduce contact resistance of the S/D contacts 494. Although FIG. 18 illustrates an example in which the S/D contacts 494 are both on the same side (e.g., a front side) of the IC structure, other examples may include one or more S/D contacts on the opposing side (e.g., a back side) of the IC structure.

FIG. 18A depicts an illustration of y-z plane in a cut along the stack 478-1 in which nanoribbons have been removed, while FIG. 18B depicts an illustration of y-z plane in a cut along the stack 478-2 in which nanoribbons have not been removed. As can be seen in FIG. 18, the process of removing the bottom two nanoribbons of the stack 478-1 (e.g., the nanoribbons 403-1 and 403-2 as shown in FIGS. 15-17) may result in cavities or recessed areas 471 in the S/D regions 459 in the stack 478-1. In one example, the recessed areas 471 are in the portion of the S/D regions 459 where nanoribbons were removed. For example, the S/D regions 459-1, 459-2 in the stack 478-1 include a first portion 475 proximate to channel regions 479 in the nanoribbons of the stack 478-1, and a second portion 477 that is further from the channel regions 479 than the first portion 475. In one such example, the S/D material 470 (e.g., a doped semiconductor material) is recessed in the areas 471 of the second portion 477, but not recessed in the first portion 475. In the illustrated example, the recessed areas 471 are between adjacent dimples 460. In other words, the spacer material 466 in the dimples 460 on sidewalls of the S/D regions 459-1, 459-2 where the nanoribbons have been removed is between adjacent recessed areas 471 of the portion 477 of the S/D regions 459-1, 459-2. In contrast, as shown in FIG. 18B, nanoribbons of the stack 478-2 have not been removed, and the S/D material 470 in the S/D regions 459-1, 459-2 in the stack has not been recessed (e.g., does not include recessed regions or areas 471).

After removal of one or more nanoribbons, the portions 477 of the S/D regions 459-1, 459-2 that were adjacent to the removed nanoribbons may be "dummy" portions of the S/D regions 459-1, 459-2 in the sense that those portions 477 may not function as source/drain regions during operation of the device. Thus, removal of at least part of the dummy portions of the S/D regions will generally not negatively impact operation of the device and may even have the advantage of reducing capacitance. Therefore, recessing of the S/D material 470 in the portions 477 where nanoribbons were removed may be intentional or a side effect of the etching processes used to remove the nanoribbons. In some examples in which the S/D material 470 is intentionally etched in the areas where nanoribbons were removed, a larger portion of the S/D regions 459-1, 459-2 may be removed than what is depicted in FIG. 18A.

The percentage of the portions 477 of the S/D regions 459-1, 459-2 that is removed may depend on a number of factors including the etching processes used to remove the nanoribbons. Excessive etching of the portions 477 of the S/D regions may cause the remaining S/D material of the portions 477 to become structurally unstable (e.g., due to the lack of adjacent structure resulting from the removal of nanoribbons). Additionally, excessive etching of the S/D material 470 close to the remaining nanoribbons of the stack 478-1 may negatively impact the operation of the resulting device. Accordingly, it may be desirable to not entirely remove S/D material 470 in the portions 477 of the S/D regions 459-1, 459-2 that were adjacent to the removed nanoribbons.

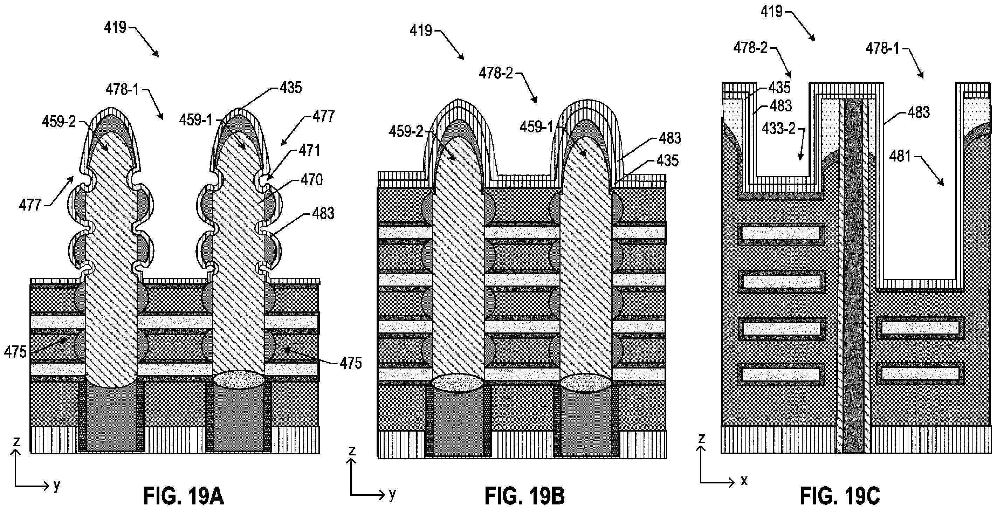

Referring again to FIG. 3B, the method 300 continues with a process 318 of removing the mask and a process 320 of providing a second liner in openings of the first and second stacks of nanoribbons. FIGS. 19A-19C illustrate an example IC structure 419 resulting from the processes 318 and 320. As can be seen in FIGS. 19A-19C, the mask 437 has been removed, revealing the lined opening 433-2 over the stack 478-2 of nanoribbons. The IC structure 419 includes a liner 483 in the opening 433-2 and the opening 481 over the stacks 478-1, 478-2 of nanoribbons. The liner may be, for example, any suitable insulator material, and may have the same material composition as the liner 435. In the example illustrated in FIG. 19, the liner 483 is in direct contact with the liner 435. In one example in which the liners 435 and 483 have the same material composition, the liners 435 and 483 over the stack 478-2 form a single liner. Thus, although the liners 435 and 483 are depicted as separate liners in FIG. 19, the liners 435 and 483 may form a single liner with different thicknesses over different portions of the IC structure 419. For example, the liners 483, 435 may form a single liner with a thickness that is greater over the stack 478-2 than the thickness of the liner 483 over the stack 478-1 in which nanoribbons were removed. In the example illustrated in FIG. 19A, the liner 483 may also be present in the recessed areas 471 of the S/D regions 459.

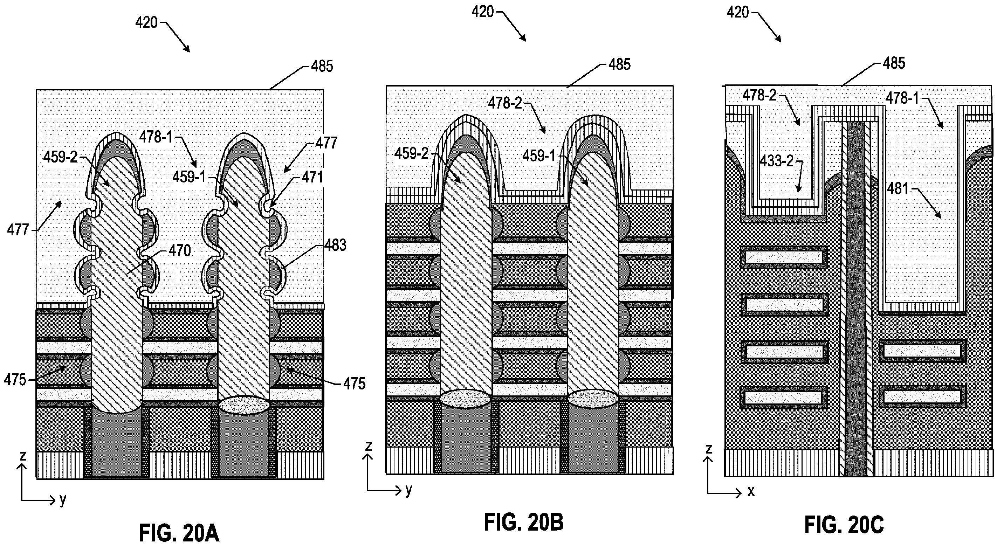

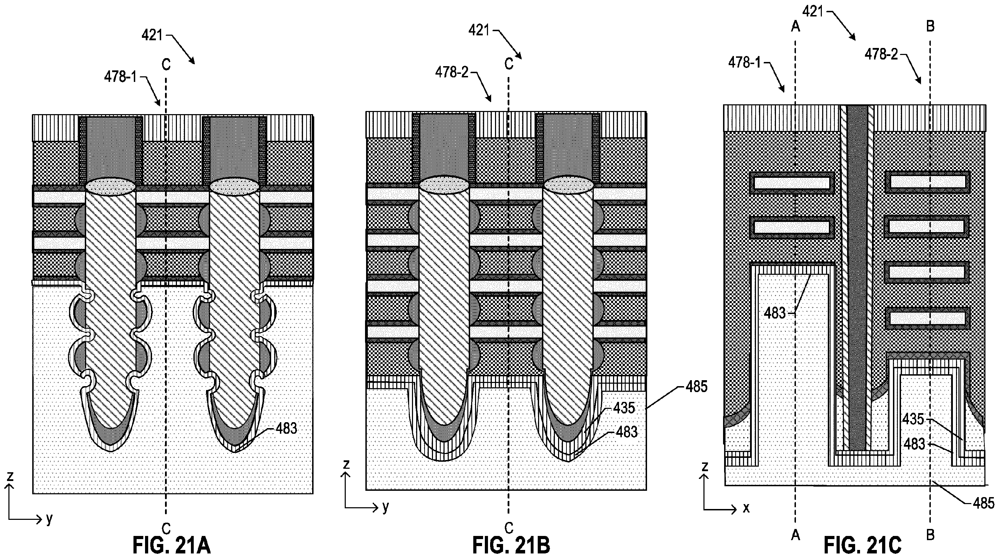

Referring to FIG. 3B, the method 300 continues with the process 322 of filling the openings with an insulator material. FIGS. 20A-20C illustrate an example IC structure 420 resulting from the process 322. As can be seen in FIGS. 20A-20C, an insulator material 485 is provided over the stacks 478-1, 478-2 of nanoribbons and over S/D regions 459-1, 459-2. In one example, the insulator material 485 fills the lined recessed areas 471 (i.e., the recessed areas 471 include the insulator material 485). In one such example, the liner 483 in the recessed areas 471 is between the insulator material 485 and the S/D material 470. FIGS. 21A-21C illustrate an example IC structure 421 resulting from flipping the IC structure over after providing the insulator material 485 over the stacks 478-1, 478-2 of nanoribbons.

The IC structures 420, 421 and all variations of such structures described herein are examples of the IC structures 100 and 200, described above. Performing the method 300 may result in features in the final IC structures that are characteristic of the use of the method 300. For example, one such feature is illustrated in the IC structures 420, 421 shown in FIGS. 20-21, which show a first stack 478-1 of nanoribbons and a second stack 478-2 of nanoribbons, where a number of nanoribbons in the first stack is less than the number of nanoribbons in the second stack. A first transistor can include channel regions in the nanoribbons of the first stack 478-1 and a second transistor can include channel regions in the nanoribbons of the second stack 478-2.

Other features may be present in the IC structures resulting from back-side nanoribbon removal, such as differences in thickness in the liner under the stacks of nanoribbons, and the thickness or height of the insulator material 485 under the stacks 478-1, 478-2. In the example illustrated in FIG. 21, a height of the insulator material 485 under the first channel regions of first stack is greater than a height of the insulator material under the second channel regions of the second stack, wherein the height is a dimension substantially orthogonal to the support over which the stacks 478-1, 478-2 are disposed (i.e., along the z-axis as shown in FIG. 21). Thus, in the illustrated example, the IC structure 421 includes an insulator material 485 under the channel regions in the nanoribbons of the stack 478-1 in the same plane as nanoribbons of the stack 278-2 (e.g., the same planes as the bottom two nanoribbons of the stack 478-2 as shown in FIG. 21). Additionally, in the example illustrated in FIG. 21, a thickness of a liner (e.g., a liner including both the liners 435, 483) between the second stack 478-1 of nanoribbons and the insulator material 485 is greater than a thickness of a liner 483 between the first stack 478-1 of nanoribbons and the insulator material 485. Although the FIGS. 4-21 depict two stacks of nanoribbons, the method 300 may be performed to fabricate many IC structures including stacks of nanoribbons.

IC structures fabricated using back-side nanoribbon removal techniques as described herein (e.g., as described with reference to FIGS. 1-21) may be used to implement any suitable components. For example, in various embodiments, transistors described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC structures disclosed herein, e.g., the IC structures 100, 200, 420, and 421 may be included in any suitable electronic component. FIGS. 22-26 illustrate various examples of apparatuses that may include any of the IC structures 100, 200, 420, and 421 disclosed herein.

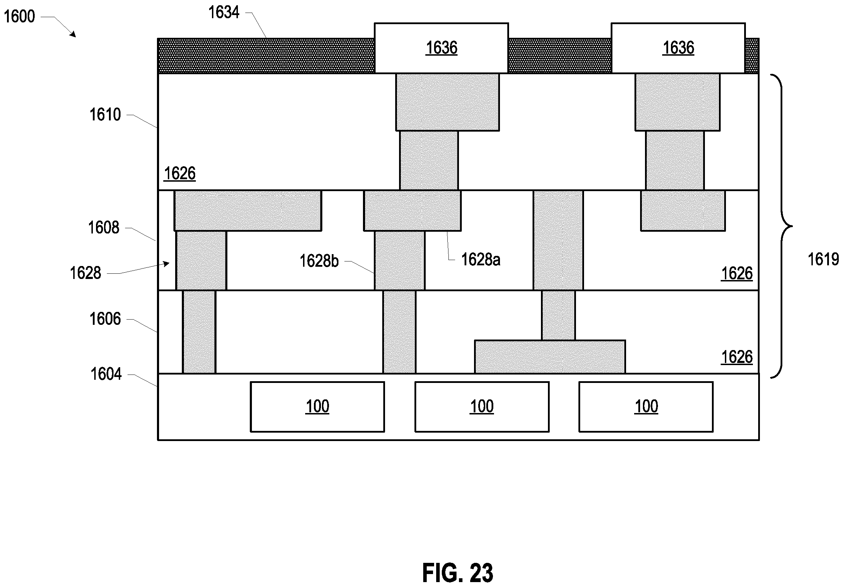

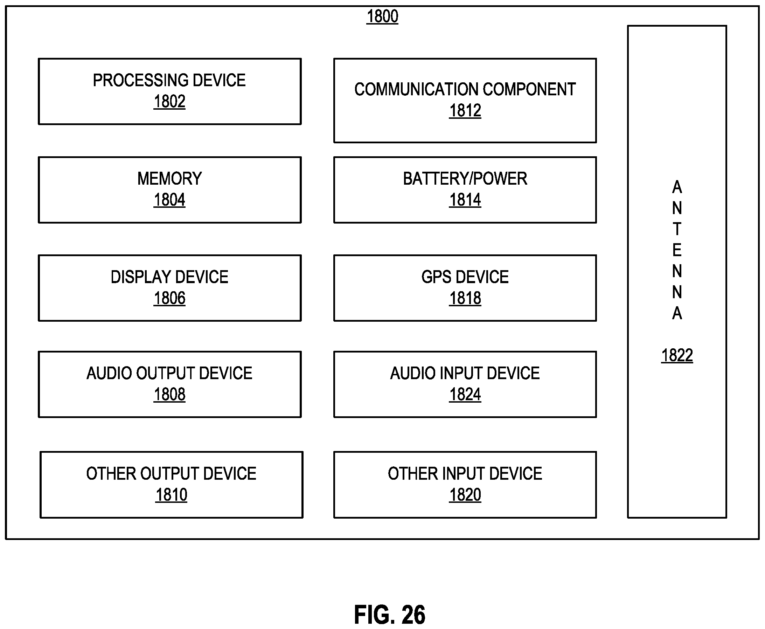

FIG. 22 is a top view of a wafer 1500 and dies 1502 that may include one or more IC structures 100, 200, 420, and 421 in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures 100, 200, 420, and 421 (e.g., as discussed below with reference to FIG. 23), one or more transistors (e.g., some of the transistors of the device region 1604 of FIG. 23, discussed below, e.g., nanoribbon-based transistors of the IC structures 100, 200, 420, and 421) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 26) or other logic that is configured to store information in the memory devices or execute instructions stored in the memory array.

FIG. 23 is a side, cross-sectional view of an IC device 1600 that may include one or more IC structures in accordance with any of the embodiments disclosed herein (e.g., in accordance with IC structures 100, 200, 420, and 421). One or more of the IC devices 1600 may be included in one or more dies 1502 (FIG. 22). The IC device 1600 may include a device region 1604 including one or more IC structures (e.g., one or more of IC structures 100, 200, 420, and 421) disclosed herein, or any variations of the IC structures. The device region 1604 may further include electrical contacts to the gates of the transistors included in the device region 1604 and to the S/D materials of the transistors included in the device region 1604 (e.g., to the S/D regions 114 of the IC structure 100).

Electrical signals, such as power and/or input/output (I/O) signals, may be routed to and/or from the devices (e.g., the transistors) of the device region 1604 through one or more interconnect layers disposed on the device region 1604 (illustrated in FIG. 23 as interconnect layers 1606-1610). For example, electrically conductive features of the device region 1604 (e.g., the gate electrode material 108 of the IC structure 100) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 23). Although a particular number of interconnect layers 1606-1610 is depicted in FIG. 23, embodiments of the present disclosure include IC structures having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the support 102 upon which the device region 1604 is formed. For example, the lines 1628a may route electrical signals in a direction in and out of the page from the perspective of FIG. 23. The vias 1628b may be arranged to route electrical signals in a direction of a plane that is substantially perpendicular to the surface of the support 102 upon which the device region 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 23. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts (e.g., contacts to the S/D regions 114 of the IC structure 100) of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606-1610. In FIG. 23, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components.

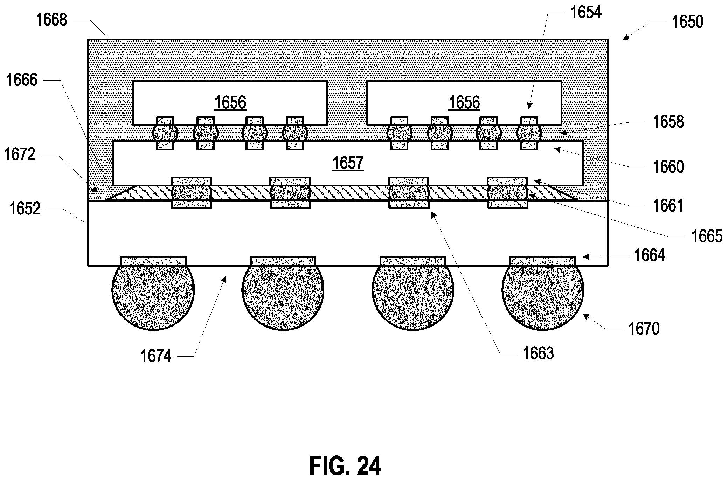

FIG. 24 is a side, cross-sectional view of an example IC package 1650 that may include one or more IC structures 100, 200, 420, and 421 in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnects 1628 discussed above with reference to FIG. 23.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 24 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 24 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

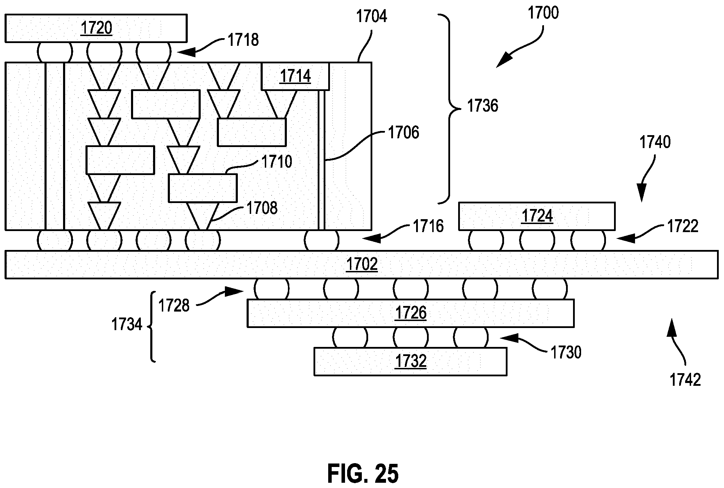

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 24 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 25.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 24 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 24, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 25 is a side, cross-sectional view of an IC device assembly 1700 that may include one or more IC packages or other electronic components (e.g., a die) including one or more IC structures 100, 200, 420, and 421 in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 24 (e.g., may include one or more IC structures 100, 200, 420, and 421).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 25 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 25), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 25, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 22), an IC device (e.g., the IC device 1600 of FIG. 23), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 25, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 25 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 26 is a block diagram of an example electrical device 1800 that may include one or more IC structures 100, 200, 420, and 421 in accordance with any of the embodiments disclosed herein. For example, any suitable ones of the components of the electrical device 1800 may include one or more of the IC device assemblies 1700, IC packages 1650, IC devices 1600, or dies 1502 disclosed herein. A number of components are illustrated in FIG. 26 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 26, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC device including a stack of nanoribbons over a support, where the stack of nanoribbons includes a first nanoribbon in a first plane substantially parallel to the support and a second nanoribbon stacked over the first nanoribbon in a second plane substantially parallel to the support. The first nanoribbon and the second nanoribbon include channel regions of a first transistor. The IC device further includes a third nanoribbon over the support in the second plane (e.g., adjacent to the second nanoribbon), where the third nanoribbon includes a channel region of a second transistor, and an insulator material under the channel region of the second transistor in the first plane.

Example 2 provides an IC device according to example 1, where the stack of nanoribbons is a first stack of nanoribbons, where the third nanoribbon is in a second stack of nanoribbons, and where the second stack has fewer nanoribbons than the first stack.

Example 3 provides an IC device according to examples 1 or 2, further including the insulator material (e.g., a materially continuous insulator material) under the stack of nanoribbons, wherein a volume of the insulator material under the channel region of the second transistor is greater than a volume of the insulator material under the channel regions of the first transistor.

Example 4 provides an IC device according to example 3, where the insulator material is a first insulator material, and where the IC device further includes a first liner including a second insulator material (e.g., nitride liner between the nanoribbons and the bunker oxide under the stack without wires removed) between the stack of nanoribbons and the insulator material, and a second liner including the second insulator material (e.g., nitride liner between the nanoribbons and the first insulator material under the stack in which nanoribbon(s) were removed) between the third nanoribbon and the insulator material, where the first liner is thicker than the second liner.

Example 5 provides an IC device according to any one of examples 1-4, further including a region of a doped semiconductor material, where the region is either a source region or a drain region of the second transistor, and where the region includes recessed areas, where the insulator material is in the recessed areas of the region.

Example 6 provides an IC device according to example 5, where the insulator material is a first insulator material, and where the IC device further includes a second insulator material (e.g., in the dimples on sidewalls of the S/D regions where the nanoribbons have been removed) between adjacent recessed areas of the region.

Example 7 provides an IC device according to example 5, where the insulator material is a first insulator material, and where the IC device further includes a liner including a second insulator material in the recessed areas of the region between the doped semiconductor material and the first insulator material.

Example 8 provides an IC device including a first stack of nanoribbons over a support and a second stack of nanoribbons over the support, where a number of nanoribbons in the first stack is less than in the second stack, and where an individual nanoribbon of the first stack is in a substantially same layer as a corresponding individual nanoribbon of the second stack, and where the plane is substantially parallel to the support. The IC device further includes a first transistor including first channel regions in the nanoribbons of the first stack and a second transistor including second channel regions in the nanoribbons of the second stack.

Example 9 provides an IC device according to example 8, further including an insulator material under the first stack of nanoribbons in a substantially same layer with one of the nanoribbons of the second stack.

Example 10 provides an IC device of example 9, further including the insulator material under the second stack of nanoribbons, where the insulator material under the first stack of nanoribbons has a first height, the insulator material under the second stack of nanoribbons has a second height, where the first height is greater than the second height, and where the first height and the second height are dimensions substantially orthogonal to the support.

Example 11 provides an IC device according to any one of examples 8-10, further including a first insulator material under the first stack of nanoribbons and under the second stack of nanoribbons, a first liner including a second insulator material between the first stack of nanoribbons and the insulator material, and a second liner including the second insulator material between the second stack of nanoribbons and the insulator material, where the second liner is thicker than the first liner.

Example 12 provides an IC device according to any one of examples 8-11, further including a region of a doped semiconductor material, where the region is either a source region or a drain region of the first transistor, and where the region includes cavities in the doped semiconductor material, and an insulator material in the cavities.

Example 13 provides an IC device according to example 12, where the insulator material is a first insulator material, and wherein the IC device further includes a second insulator material (e.g., in the dimples on sidewalls of the S/D regions where one or more nanoribbons have been removed) between adjacent cavities.

Example 14 provides an IC device according to example 12, where the insulator material is a first insulator material, and where the IC device further includes a liner including a second insulator material in the cavities between the doped semiconductor material and the first insulator material.

Example 15 provides an IC structure including one or more nanoribbons over a support, where portions of the one or more nanoribbons include channel regions of a transistor, and a region of a doped semiconductor material, where the region is either a source region or a drain region of the transistor, and where the region includes a first portion proximate to the channel regions, and a second portion that is further from the channel regions than the first portion, where the doped semiconductor material is recessed in areas of the second portion, and where the recessed areas include an insulator material.

Example 16 provides an IC structure according to example 15, where the one or more nanoribbons are first nanoribbons and the channel regions are first channel regions of a first transistor, and where the IC structure further includes second nanoribbons stacked over one another over the support, where portions of the second nanoribbons include second channel regions of a second transistor, where the first nanoribbons include a first number of nanoribbons and the second nanoribbons include a second number of nanoribbons that is greater than the first number.

Example 17 provides an IC structure according to example 16, where the first transistor includes the first channel regions in the first number of nanoribbons and the second transistor includes the second channel regions in the second number of nanoribbons.

Example 18 provides an IC structure according to any one of examples 15-17, where the insulator material is a first insulator material, and where the IC structure further includes a second insulator material between adjacent recessed areas of the second portion.

Example 19 provides an IC structure of any one of examples 15-18, where the insulator material is a first insulator material, and where the IC device further includes a liner including a second insulator material in the recessed areas of the second portion between the doped semiconductor material and the first insulator material.

Example 20 provides an IC structure of any one of examples 15-19, where the insulator material is a first insulator material, and where the IC structure further includes a conductive material around the channel portions in the one or more nanoribbons, and a second insulator material between the channel portions and the conductive material, a liner between the first insulator material and the one or more nanoribbons, and a layer of the second insulator material between the liner and the conductive material under the one or more nanoribbons.

Example 21 provides an IC structure according to any one of examples 1-20, where the IC structure includes or is a part of a central processing unit.

Example 22 provides an IC structure according to any one of examples 1-21, where the IC structure includes or is a part of a memory device.

Example 23 provides an IC structure according to any one of examples 1-22, where the IC structure includes or is a part of a logic circuit.

Example 24 provides an IC structure or IC device according to any one of examples 1-23, where the IC structure or IC device includes or is a part of input/output circuitry.

Example 25 provides an IC structure or IC device according to any one of examples 1-24, where the IC structure or IC device includes or is a part of a field programmable gate array transceiver.

Example 26 provides an IC structure or IC device according to any one of examples 1-25, where the IC structure or IC device includes or is a part of a field programmable gate array logic.

Example 27 provides an IC structure or IC device according to any one of examples 1-26, where the IC structure or IC device includes or is a part of a power delivery circuitry.

Example 28 provides an IC package that includes an IC die including an IC structure or IC device according to any one of examples 1-27; and a further IC component, coupled to the IC die.

Example 29 provides an IC package according to example 28 where the further IC component includes a package substrate.

Example 30 provides an IC package according to example 28, where the further IC component includes an interposer.

Example 31 provides an IC package according to example 28, where the further IC component includes a further IC die.

Example 32 provides a computing device that includes a carrier substrate and an IC structure or IC device coupled to the carrier substrate, where the IC structure or device is an IC structure or device according to any one of examples 1-27, or the IC structure or device is included in the IC package according to any one of examples 28-31.

Example 33 provides a computing device according to example 32, where the computing device is a wearable or handheld computing device.

Example 34 provides a computing device according to examples 32 or 33, where the computing device further includes one or more communication chips.

Example 35 provides a computing device according to any one of examples 32-34, where the computing device further includes an antenna.

Example 36 provides a computing device according to any one of examples 32-35, where the carrier substrate is a motherboard.

Example 37 provides a method of fabricating an IC structure, the method including providing a first stack of nanoribbons and a second stack of nanoribbons over a support from a first side of the IC structure (e.g., where the stacks of nanoribbons initially have the same number of nanoribbons), forming a first region in the first stack of nanoribbons and a second region in the second stack of nanoribbons, where the first region is a source or drain region of a first transistor and the second region is a source or drain region of a second transistor, providing a conductive material around portions of the nanoribbons of the first stack and around portions of the nanoribbons of the second stack, flipping over the IC structure to reveal a second side of the IC structure, removing one or more nanoribbons from the first stack of nanoribbons (without removing nanoribbons from the stack, or removing fewer nanoribbons from the second stack), where after the removal of the one or more nanoribbons, the first stack of nanoribbons includes at least one nanoribbon, and has fewer nanoribbons than the second stack. The method further involves forming a first transistor having first channel portions in the first stack of nanoribbons and forming a second transistor having second channel portions in the second stack of nanoribbons.

Example 38 provides a method according to example 37, where removing the one or more nanoribbons from the first stack of nanoribbons includes etching an insulator material, a conductive material, and a semiconductor material of one of the nanoribbons of the first stack, and stopping on a layer of the insulator material (e.g., after etching the semiconductor material of the nanoribbon to remove).

Example 39 provides a method according to examples 37 or 38, where removing the one or more nanoribbons involves removing two or more nanoribbons from the first stack, including cyclically etching an insulator material, a conductive material, and a semiconductor material of one of the nanoribbons, and stopping on a layer of the insulator material (e.g., after etching the semiconductor material of the last nanoribbon to remove).

Example 40 provides a method according to examples 38 or 39, where etching the semiconductor material of one of the nanoribbons includes (e.g., intentionally or unintentionally) etching a second semiconductor material of a source region or a drain region adjacent to the semiconductor material.

Example 41 provides a method according to of any one of examples 38-40, where the insulator material is a first insulator material, and where the method further includes providing a liner over the layer of the first insulator material in an opening resulting from the removal of the one or more nanoribbons, where the liner includes a second insulator material, and filling the opening with a third insulator material.

Example 42 provides a method according to any one of examples 37-41, further including prior to removing the one or more nanoribbons from the first stack, forming openings over the first stack of nanoribbon and over the second stack of nanoribbons (e.g., by removing a semiconductor material over the first stack of nanoribbons and over the second stack of nanoribbons) and providing a liner in the openings.

Example 43 provides a method according to any one of examples 37-42, further including prior to removing the one or more nanoribbons from the first stack, providing a mask over a second side of the IC structure, where the mask covers the second stack of nanoribbons and has an opening over the first stack of nanoribbons (e.g., an opening sufficiently wide to enable removal of one or more nanoribbons through the opening in the mask).

Example 44 provides a method of example 43, further including after removing the one or more nanoribbons from the first stack, removing the mask, revealing a first opening over the first stack and a second opening over the second stack, the second opening including the liner where the liner is a first liner. The method further includes providing a second liner over the first liner in the second opening and in the first opening and filling the first opening and the second opening with an insulator material.

Example 45 provides a method according to any one of examples 37-44, where forming the stacks of nanoribbons includes providing alternate layers of a semiconductor material and a further material and forming fins from the alternate layers of the semiconductor material and the further material.

Example 46 provides a method according to any one of examples 37-45, where forming the first transistor and forming the second transistor include forming conductive contact structures coupled with the source region and the drain region.

Example 47 provides a method according to example 45, where forming the first transistor and forming the second transistor include removing the further material from around the layers of the semiconductor material, releasing the nanoribbons, providing a conductive material around channel regions in the nanoribbons, and forming a conductive contact structure coupled with the conductive material.

Example 48 provides a method according to any one of examples 37-47, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a stack of nanoribbons over a substrate including a first nanoribbon in a first plane substantially parallel to the substrate and a second nanoribbon stacked over the first nanoribbon in a second plane substantially parallel to the substrate, wherein the first nanoribbon and the second nanoribbon include channel regions of a first transistor;
a third nanoribbon over the substrate in the second plane, wherein the third nanoribbon includes a channel region of a second transistor; and
an insulator material under the channel region of the second transistor in the first plane.

2. The IC device of claim 1, wherein the stack of nanoribbons is a first stack of nanoribbons, and wherein:
the third nanoribbon is in a second stack of nanoribbons, wherein the second stack has fewer nanoribbons than the first stack.

3. The IC device of claim 2, wherein:
the second stack has one fewer nanoribbon than the first stack.

4. The IC device of claim 2, wherein:
the second stack has half as many nanoribbons as the first stack.

5. The IC device of any one of claims 1-4, further comprising:
the insulator material under the stack of nanoribbons, wherein a volume of the insulator material under the channel region of the second transistor is greater than a volume of the insulator material under the channel regions of the first transistor.

6. The IC device of claim 5, wherein the insulator material is a first insulator material, and wherein the IC device includes:
a first liner including a second insulator material between the stack of nanoribbons and the first insulator material; and
a second liner including the second insulator material between the third nanoribbon and the first insulator material;
wherein the first liner is thicker than the second liner.

7. The IC device of any one of claims 1-6, further comprising:
a region of a doped semiconductor material, wherein the region is either a source region or a drain region of the second transistor, and wherein the region includes recessed areas;
wherein the insulator material in the recessed areas of the region.

8. The IC device of claim 7, wherein the insulator material is a first insulator material, and wherein the IC device further includes:
a second insulator material between adjacent recessed areas of the region.

9. The IC device of claim 7 or 8, wherein the insulator material is a first insulator material, and wherein the IC device further includes:
a liner including a second insulator material in the recessed areas of the region between the doped semiconductor material and the first insulator material.

10. A method of fabricating an integrated circuit (IC) structure, the method comprising:
forming stacks of nanoribbons over a support from a first side of the IC structure, the stacks of nanoribbons including a first stack of nanoribbons and a second stack of nanoribbons;
flipping over the IC structure to reveal a second side of the IC structure;
removing one or more nanoribbons from the first stack of nanoribbons, wherein after the removal of the one or more nanoribbons, the first stack of nanoribbons includes at least one nanoribbon, and has fewer nanoribbons than the second stack;
forming a first transistor having first channel portions in the first stack of nanoribbons; and
forming a second transistor having second channel portions in the second stack of nanoribbons.

11. The method of claim 10, wherein:
removing the one or more nanoribbons from the first stack of nanoribbons includes:
etching an insulator material and a conductive material, and a semiconductor material of one of the nanoribbons of the first stack, and
stopping on a layer of the insulator material.

12. The method of claim 10, wherein:
removing the one or more nanoribbons involves removing two or more nanoribbons from the first stack, including:
cyclically etching an insulator material and a conductive material, and a semiconductor material of one of the nanoribbons, and
stopping on a layer of the insulator material.

13. The method of claims 11 or 12, wherein:
the semiconductor material is a first semiconductor material, and
etching the first semiconductor material of one of the nanoribbons includes further etching a second semiconductor material of a source region or a drain region adjacent to the first semiconductor material.

14. The method of any one of claims 11-13, wherein the insulator material is a first insulator material, and wherein the method further comprises:
providing a liner over the layer of the first insulator material in an opening, wherein the opening is from the removal of the one or more nanoribbons, and wherein the liner includes a second insulator material; and
filling the opening with a third insulator material.

15. The method of any one of claims 11-14, further comprising:
prior to removing the one or more nanoribbons from the first stack, removing a semiconductor material over the first stack of nanoribbons and over the second stack of nanoribbons; and
providing a liner in openings from the removal of the semiconductor material.
